# EUROPÄISCHE PATENTSCHRIFT

(11) **EP 2 025 053 B1**
(45) Veröffentlichungstag und Bekanntmachung des Hinweises auf die Patenterteilung: **15.12.2010**
(21) Anmeldenummer: 07723401.1
(22) Anmeldetag: 20.03.2007
(51) Int. Cl.: H02P 6/00, H03K 17/60

(54) **ELEKTROMOTOR**
ELECTRIC MOTOR
MOTEUR ELECTRIQUE

(30) Priorität: 03.06.2006 DE 202006009033 U
(43) Veröffentlichungstag der Anmeldung: 18.02.2009
(73) Patentinhaber: ebm-papst St. Georgen GmbH & Co. KG, 78112 St. Georgen (DE)
(72) Erfinder: ZIPSER, Thomas, 78112 St. Georgen (DE); LÖFFLER, Jens, D-78050 Villingen- Schwenningen (DE)
(74) Vertreter: Raible, Tobias
(86) Internationale Anmeldenummer: PCT/EP2007/002434
(87) Internationale Veröffentlichungsnummer: WO 2007/140832

(56) Entgegenhaltungen:
- "HIgh Voltage Hall-Effect Smart Fan Motor Controller" [Online] 17. Januar 2005 (2005-01-17), ANACHIP CORP. , XP002453521 Gefunden im Internet: URL:http://pdf1.alldatasheet.com/datasheet -pdf/view/127739/ANACHIP/AH287.html> [gefunden am 2007-10-01] in der Anmeldung erwähnt das ganze Dokument
- "Brushless DC motor Controller" [Online] 2005, TEXAS INSTRUMENTS INCORPORATED , XP002453522 Gefunden im Internet: URL:http://pdf1.alldatasheet.com/datasheet -pdf/view/29340/TI/UC2625.html> [gefunden am 2007-10-01] das ganze Dokument

## Beschreibung

Die Erfindung betrifft einen elektronisch kommutierten Elektromotor (ECM).

Es gibt integrierte Motorsteuerbausteine mit einer internen Endstufe zum direkten Anschluss wenigstens eines Statorstrangs eines ECM. Wegen der in der internen Endstufe dieses Bausteins erzeugten Wärme haben solche Bausteine den Nachteil, dass sie bei hohen Außentemperaturen nur noch geringe Leistungsreserven haben, d.h. sie ermöglichen dann nur noch geringe Motorleistungen, bzw. ein Betrieb des Motors ist dann überhaupt nicht mehr möglich. Im Englischen spricht man von dem so genannten "derating", d.h. die maximale Leistung ist abhängig von der Umgebungstemperatur bzw. der Temperatur des Motorsteuerbausteins und nimmt mit zunehmender Temperatur ab bzw. wird immer stärker begrenzt.

Aus dem Firmenprospekt High Voltage Hall-Effect Smart Fan Motor Controller (Online) 17. Januar 2005 (2005-01-17), ANACHIP CORP., XP002453521 Gefunden im Internet: URL:http://pdf1.alldatasheet.com/datasheet - kennt man einen elektronisch kommutierten Elektromotor mit einem permanentmagnetischen Rotor, einem Stator mit einer Statorwicklungsanordnung, ferner mit zwei integrierten Endstufen zur Beeinflussung der Bestromung der Statorwicklungsanordnung, einen als IC ausgebildeten integrierten Motorsteuerbaustein AH287 mit einer Steuerlogik und einer internen Endstufe mit mindestens einem Open-Collector-Ausgang, wobei die Steuerlogik dazu ausgebildet ist, ein Rotorstellungssignal von einem in den IC integrierten Hallsensor zu verarbeiten und daraus mindestens ein Steuersignal für die interne Endstufe zu erzeugen, welches mindestens eine Steuersignal dazu dient, die interne Endstufe zur Erzeugung eines Ausgangssignals an dem mindestens einen Open-Collector-Ausgang des Motorsteuerbausteins anzusteuern. Dieser integrierte Baustein wird in elektronisch kommutierten Gleichstromlüftern verwendet und enthält Bauteile, die den Lüfter abschalten, wenn er blockiert wird.

Es ist deshalb eine Aufgabe der Erfindung, einen neuen ECM bereit zu stellen, der auch bei höheren Umgebungstemperaturen betrieben werden kann.

Nach der Erfindung wird diese Aufgabe gelöst durch einen ECM gemäß Anspruch 1. Bevorzugte Ausführungsformen sind Gegenstand der Unteransprüche.

Ein solcher Motor kann auch bei höheren Temperaturen betrieben werden. Die Kombination aus interner Endstufe, Invertierungslogik und externer Endstufe ermöglicht eine Vielzahl an Schaltungsvarianten, mit denen z.B. die Schaltgeschwindigkeit der Endstufe beeinflusst und an den entsprechenden Anwendungsfall angepasst werden kann.

Weitere Einzelheiten und vorteilhafte Weiterbildungen der Erfindung ergeben sich aus den im folgenden beschriebenen und in den Zeichnungen dargestellten, in keiner Weise als Einschränkung der Erfindung zu verstehenden Ausführungsbeispielen, sowie aus den Unteransprüchen. Es zeigt:
- Fig. 1: ein Schaltbild einer Vorrichtung zum Betrieb eines Elektromotors gemäß einer Ausführungsform der Erfindung,
- Fig. 2: ein Schaltbild der externen Endstufe von Fig. 1 gemäß einer anderen Ausführungsform der Erfindung,
- Fig. 3: eine schematische Darstellung einer Kennlinie für die Vorrichtung gemäß Fig. 1 oder Fig. 2,
- Fig. 4: ein Schaltbild der Vorrichtung von Fig. 1 mit einem Drehzahlausgang gemäß einer Weiterbildung der Erfindung, und
- Fig. 5: ein Schaltbild der Vorrichtung gemäß Fig. 1 mit einer zusätzlichen Einrichtung zur Stabilisierung der Versorgungsspannung.

In der nachfolgenden Beschreibung werden gleiche oder gleich wirkende Teile in den verschiedenen Figuren mit denselben Bezugszeichen bezeichnet und gewöhnlich nur einmal beschrieben.

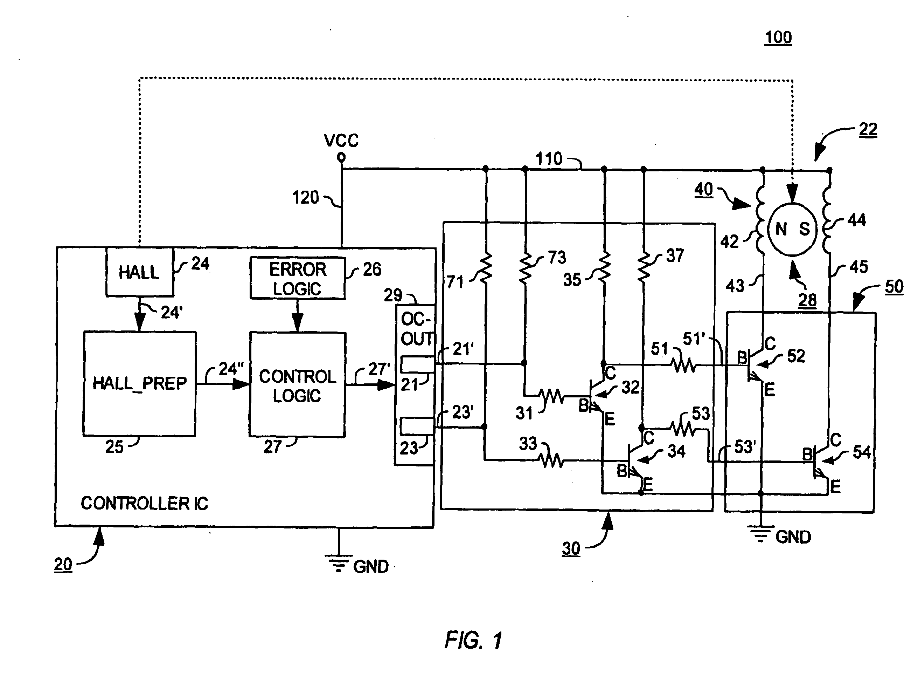

Fig. 1 zeigt ein Schaltbild einer Vorrichtung 100 zum Betrieb eines ECM 22, welcher einen permanentmagnetischen Rotor 28 und eine Statorwicklungsanordnung 40 hat. Letztere ist beispielhaft zweisträngig dargestellt, d.h. mit zwei Wicklungssträngen 42, 44. Diese sind einerseits über eine Versorgungsleitung 110 mit einer Gleichspannungsquelle VCC und andererseits mit einer externen Endstufe 50 verbunden. Die Spannungsquelle VCC ist über eine Versorgungsleitung 120 mit einem Motorsteuerbaustein 20 (CONTROLLER IC) verbunden. Die mit der Versorgungsleitung 110 verbundenen Enden der Stränge 42, 44 werden im Folgenden als "obere" Enden bezeichnet, während die mit der externen Endstufe 50 verbundenen Enden als "untere" Enden 43, 45 bezeichnet werden.

Die externe Endstufe 50 dient zur Beeinflussung der Ströme in den Wicklungssträngen 42, 44 und hat zwei Halbleiterschalter, welche in Fig. 1 beispielhaft als Bipolartransistoren 52, 54 dargestellt sind. (Nachfolgend wird auch eine Version mit Feldeffekttransistoren beschrieben). Der Kollektor des Transistors 52 ist mit dem unteren Ende 43 des Strangs 42 verbunden, sein Emitter mit Masse (GND), und seine Basis mit einer Invertierungslogik 30. Analog ist der Kollektor des Transistors 54 mit dem unteren Ende 45 des Strangs 44 verbunden, sein Emitter mit Masse (GND) und seine Basis mit der Invertierungslogik 30.

Letztere dient zur Erzeugung geeigneter Kommutierungssignale 51', 53' für die externe Endstufe 50 und hat zwei Halbleiterschalter, welche in Fig. 1 beispielhaft als Bipolartransistoren 32, 34 dargestellt sind, sowie acht Widerstände 31, 33, 35, 37, 51, 53, 71, 73. Der Kollektor des Transistors 32 ist über den Widerstand 35 mit der Versorgungsleitung 110 und über den Widerstand 51 mit der Basis des Transistors 52 verbunden. Sein Emitter ist mit Masse (GND) verbunden, und seine Basis ist über den Widerstand 31 einerseits mit einem Open-Collector-Ausgang 21 des Motorsteuerbausteins 20 verbunden zwecks Zuführung eines Ausgangssignals 21', und andererseits über den Widerstand 73 mit der Leitung 110. Analog ist der Kollektor des Transistors 34 über den Widerstand 37 mit der Leitung 110 und über den Widerstand 53 mit der Basis des Transistors 54 verbunden. Sein Emitter ist mit Masse verbunden und seine Basis ist über den Widerstand 33 einerseits mit dem Open-Collector-Ausgang 23 des Motorsteuerbausteins 20 zwecks Zuführung eines Ausgangssignals 23', andererseits über den Widerstand 71 mit der Leitung 110 verbunden.

In dem dargestellten Baustein 20 sind integriert:
- Ein Hallsensor 24 (HALL);
- eine Rotorstellungs-Aufbereitungseinheit 25 (HALL_PREP);
- eine Fehlerlogik 26 (ERROR LOGIC);
- eine interne Steuerlogik 27 (CONTROL LOGIC), die auch für die Bestromung und Kommutierung zuständig ist;
- und eine Ausgabeeinheit bzw. interne Endstufe 29 (OC-OUT) mit mindestens einem Open-Collector-Ausgang.

Der Baustein 20 kann als platzsparender Motorsteuer-IC realisiert werden, den es auch als ASIC-Baustein gibt. Derartige Motorsteuer-ICs sind am Markt verfügbar, z.B. der AH287 von der Fa. Anachip oder der PT3911 von der Fa. Prolific Technology Inc. Die Bausteine 20 dienen üblicherweise dazu, die unteren Enden 43, 45 der Stränge 42, 44 direkt an die Open-Collector-Ausgänge 21, 23 anzuschließen und entsprechende Ausgangssignale 21', 23' zur Bestromung bzw. Kommutierung zu erzeugen. Sie sind z.B. mit einer Leistung bis zu 2 Watt und einem Spannungsbereich zwischen 2,8 V und 28 V erhältlich.

Der integrierte Hallsensor (Rotorstellungssensor) 24 ist im Magnetfeld des Rotors 28 angeordnet, um im Betrieb ein Rotorstellungssignal 24' zu erzeugen. Alternativ kann ein beliebiger, auch externer, Rotorstellungssensor verwendet werden. Dies kann insofern nachteilig sein, weil ein solcher Sensor üblicherweise einen Kondensator für die Erzeugung eines Blockiertakts mit entsprechenden Kosten und entsprechendem Platzbedarf benötigt, außerdem eine Stabilisierungsschaltung zur Spannungsstabilisierung, um eine Überlastung zu vermeiden und eine ausreichend exakte Messung zu ermöglichen. Ebenso ist eine Erfassung der Drehstellung des Rotors 28 über das so genannte Sensorless-Prinzip möglich, wie dem Fachmann bekannt ist. In Fig. 1 ist der Hallsensor 24 als integrierte Komponente des Bausteins 20 dargestellt.

Die Rotorstellungssignal-Aufbereitungseinheit 25 dient zur Aufbereitung des vom Hallsensor 24 erzeugten Rotorstellungssignals 24', und sie erzeugt ein Rotorstellungssignal 24". Die Steuereinheit 27 erzeugt aus dem Rotorstellungssignal 24" ein Signal 27' zur Ansteuerung der Endstufe 29 mit ihren Leistungsbauteilen, um die Kommutierung und Bestromung der Statorwicklungsanordnung 40 zu bewirken. Die Endstufe 29 hat bei der Anordnung nach Fig. 1 zwei Open-Collector-Ausgänge 21, 23. Andere Zahlen solcher Ausgänge sind möglich.

Die Fehlerlogik 26 dient als Blockierschutz für den ECM 22 und schaltet diesen bei einem Fehler aus, z. B., wenn der Rotor 28 mechanisch blockiert ist. Hierzu erzeugt die Fehlerlogik 26 ein Fehlersignal für die Steuereinheit 27. Letztere erzeugt auf Basis des Fehlersignals die Kommutierungssignale derart, dass die externe Endstufe 50 ausgeschaltet wird. Somit kann z.B. beim Blockieren des Rotors 28 eine Überhitzung des ECM 22 durch eine fortgesetzte Bestromung der Statorwicklungsanordnung 40 verhindert werden, und ein sicherer Wiederanlauf nach dem Blockieren wird ermöglicht.

### Arbeitsweise

Im Betrieb erzeugt der Motorsteuerbaustein 20 Signale 21', 23' für den ECM 22. Hierzu erfasst der Hallsensor 24 die Drehstellung des Rotors 28 und erzeugt ein Rotorstellungssignal 24', das in der Einheit 25 aufbereitet wird. In der Steuereinheit 27 werden abhängig vom aufbereiteten Rotorstellungssignal 24" und abhängig vom Zustand der Fehlereinheit 26 Steuersignale 27' für die interne Endstufe 29 erzeugt. Diese wird durch die Steuersignale 27' derart angesteuert, dass sie Signale zur Kommutierung des ECM 22 erzeugt, welche über die Ausgänge 21, 23 als Signale 21', 23' ausgegeben werden.

Die Open-Collector-Ausgänge 21, 23 ermöglichen einen direkten Anschluss der unteren Enden 43, 45 der Stränge 42, 44. Daher wird an dem Open-Collector-Ausgang 21 ein logisches Signal "LOW" ausgegeben, wenn der Wicklungsstrang 42 Strom erhalten soll, d.h. der Ausgang 21 wird mit Masse "GND" verbunden. Analog wird am Ausgang 23 ein logisches Signal "LOW" ausgegeben, wenn der Wicklungsstrang 44 Strom erhalten soll, wobei bevorzugt in jedem Augenblick an höchstens einem der Ausgänge 21, 23 ein logisches Signal "LOW" ausgegeben wird.

Zur Unterbrechung der Bestromung eines oder beider Wicklungsstränge 42, 44 wird an dem zugeordnetem Ausgang 21, 23 ein logisches Signal "TRISTATE" erzeugt, d.h. die Ausgänge 21, 23 werden hochohmig geschaltet, so dass an ihnen kein Steuerstrom abgenommen werden kann. Eine Unterbrechung der Bestromung beider Wicklungsstränge 42, 44 ist u.a. in der so genannten Bestromungslücke und, im Fehlerfall, beim Blockieren des Rotors 28 erforderlich, wie beschrieben.

Da die Ausgänge 21, 23 bei den Schaltungen nach Fig. 1, 4 und 5 nicht direkt mit den unteren Enden 43, 45 der Wicklungen verbunden sind, sondern zur Ansteuerung der externen Endstufe 50, 50' etc. verwendet werden, werden die Ausgangssignale 21', 23' durch die Invertierungslogik 30 invertiert. Hierdurch wird das am Ausgang 21 erzeugte Ausgangssignal 21' durch den Transistor 32 invertiert, und analog wird das am Ausgang 23 erzeugte Ausgangssignal 23' durch den Transistor 34 invertiert. Am Kollektor des Transistors 32 bzw. 34 wird ein logisches Signal "HIGH" als Kommutierungssignal für die externe Endstufe 50 erzeugt, wenn an seiner Basis ein logisches Signal "LOW" anliegt, und umgekehrt.

Geeignete Schaltschwellen bzw. Ein- und Ausschaltzeitpunkte für die Transistoren 32, 34 können mittels der Widerstände 31, 33, 71, 73 eingestellt werden.

Die an den Kollektoren der Transistoren 32, 34 erzeugten Signale sind die Kommutierungssignale für die externe Endstufe 50. Diese bewirken, dass der Transistor 52 bzw. 54 eingeschaltet wird bzw. ist, wenn an seiner Basis - und somit am Kollektor des Transistors 32 bzw. 34 - ein logisches Signal "HIGH" erzeugt wird. Durch das Einschalten des Transistors 52 bzw. 54 wird bewirkt, dass ein Strom durch diesen Transistor und den zugeordneten Wicklungsstrang 42 bzw. 44 fließt. Umgekehrt wird bzw. ist der Transistor 52 bzw. 54 ausgeschaltet, wenn an seiner Basis - und somit am Kollektor des Transistors 32 bzw. 34 - ein logisches Signal "LOW" erzeugt wird. Da hierdurch ein Strom durch den Transistor 52 bzw. 54 unterbunden wird, fließt auch kein Strom durch den zugeordneten Strang 42 bzw. 44. Dementsprechend wird die Bestromung beider Stränge 42, 44 unterbrochen, wenn beide Transistoren 52, 54 ausgeschaltet sind.

Die Einstellung geeigneter Ein- und Ausschaltzeitpunkte der externen Endstufe 50 erfolgt durch ein von den Widerständen 35, 37, 51, 53 gebildetes Verzögerungsglied, welches beispielhaft als integrierter Bestandteil der Invertierungslogik 30 dargestellt ist. Es wird jedoch darauf hingewiesen, dass es auch als Teil der externen Endstufe 50 oder als separates Bauteil ausgeführt werden kann. Das Verzögerungsglied kann dazu verwendet werden, Spannungen zu reduzieren, welche sonst bei der Kommutierung in den Wicklungssträngen 42, 44 auftreten würden.

Die Invertierungslogik 30 ermöglicht mit einer nur geringen Anzahl an Bauteilen, und damit kostengünstig, den - eigentlich nicht vorgesehenen - Anschluss der externen Endstufe 50 an die interne Endstufe 29. Die Aufteilung der Verlustleistung auf die interne Endstufe 29 und die externe Endstufe 50 ermöglicht den Betrieb des Motors auch bei höheren Temperaturen und Leistungsklassen, die über denen der Spezifikation des Motorsteuerbausteins liegen.

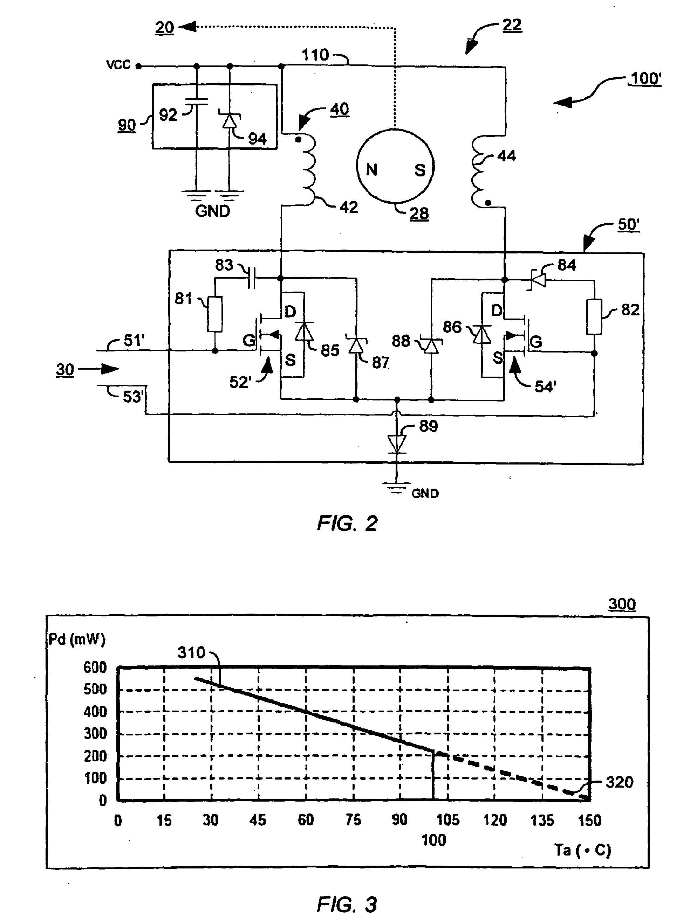

Fig. 2 zeigt eine teilweise Darstellung einer erweiterten Variante 100' zur Vorrichtung 100 gemäß Fig. 1. Diese Variante hat ebenfalls einen ECM 22, einen Baustein 20, und eine Invertierungslogik 30. Im Gegensatz zu Fig. 1 hat die Vorrichtung 100' eine Spannungsbegrenzung 90 und eine anders ausgestaltete externe Endstufe 50'.

Die Spannungsbegrenzung 90 dient zur Begrenzung von Spannungsspitzen, welche von einer induzierten Spannung erzeugt werden, die bei einer Kommutierung durch die externe Endstufe 50' in der Statorwicklungsanordnung 40 induziert wird. Diese induzierte Spannung bewirkt einen Rückspeisestrom, welcher in den Zwischenkreis 110 und folglich zur Spannungsbegrenzung 90 rückgespeist wird.

Wie Fig. 2 zeigt, hat die Spannungsbegrenzung 90 einen Zwischenkreiskondensator 92 und/oder eine Zenerdiode 94 oder beides. Diese sind parallel zueinander zwischen der Leitung 110 und Masse angeordnet. Der Kondensator 92 dient zur Aufnahme des Rückspeisestroms und nimmt somit überschüssige Energie aus den Strängen 42, 44 auf, wodurch entsprechende Spannungsspitzen reduziert werden. Die Z-Diode 94 dient als Schutz des Zwischenkreiskondensators 92 und begrenzt eine an diesem anliegende Zwischenkreisspannung. Dies schützt die gesamte Elektronik.

Die externe Endstufe 50' ist, im Gegensatz zur externen Endstufe 50 gemäß Fig. 1, mit zwei Feldeffekttransistoren 52', 54' mit internen Freilaufdioden 85 bzw. 86 dargestellt. Zur Begrenzung der Drain-Spannung dieser FETs 52', 54' hat die externe Endstufe 50' ein Spannungsbegrenzungsglied mit einer Vielzahl von Elementen, welche getrennt voneinander oder in beliebigen Kombinationen verwendet werden können. Dementsprechend sind die im Folgenden beschriebenen Elemente nur als Beispiele für geeignete Spannungsbegrenzungen anzusehen.

Eine wirksame Spannungsbegrenzung kann durch Z-Dioden 87, 88 realisiert werden. Die Anode der Z-Diode 87 ist hierzu mit der Source (S) und ihre Katode mit dem Drain (D) des FET 52' verbunden. Analog ist die Anode der Z-Diode 88 mit der Source (S) des FET 54' verbunden; ihre Katode ist mit dessen Drain verbunden. Eine weitere Spannungsbegrenzung wird durch eine Fußpunktdiode 89 realisiert, deren Anode mit den Source-Anschlüssen beider FETs 52', 54' verbunden ist. Ihre Katode ist mit Masse verbunden. Eine weitere Spannungsbegrenzung wird durch eine Schaltung zum Verlangsamen des Ein-und Ausschaltens der FETs 52', 54' erzielt. Hierzu ist das Gate des Transistors 52' über einen Widerstand 81 und einen Kondensator 83, welche ein RC-Glied bilden, mit dem Drain des Transistors 52' verbunden. Das Gate des FET 54' ist über einen Widerstand 82 mit der Anode einer Z-Diode 84 verbunden, deren Katode mit dem Drain des Transistors 54' verbunden ist. Das RC-Glied und das Widerstands-Z-Dioden-Glied sind alternative Möglichkeiten zur Verlangsamung der Ein- und Ausschaltvorgänge der Transistoren 52', 54'. Auch bei der Schaltung gemäß Fig. 2 kann an beiden Transistoren 52', 54' ein RC-Glied oder ein Widerstands-Z-Dioden-Glied vorgesehen werden.

Dem Fachmann ist klar, dass er von den in Fig. 2 und in den folgenden Figuren beschriebenen Komponenten nur diejenigen verwenden muss, die für den gegebenen Anwendungsfall notwendig sind.

Fig. 3 zeigt eine schematische Darstellung 300 einer beispielhaften Kennlinie 310, welche die im Betrieb der Vorrichtung 100 von Fig. 1 bzw. 100' von Fig. 2 zulässige Außen- bzw. Umgebungstemperatur (Ta) in Abhängigkeit von einer jeweils auftretenden internen Verlustleistung (Pd) des Motorsteuerbausteins 20 darstellt.

Die internen Verluste, und die augenblickliche Umgebungstemperatur, führen zu einer Erwärmung des Bausteins 20, welche dessen ordnungsgemäßen Betrieb beeinträchtigen kann. Hierbei ist besonders die Temperaturempfindlichkeit des Hallsensors 24 kritisch, da dieser bei zu starker Erwärmung ein undefiniertes Schalten der internen Endstufe 27 bewirken kann. Deshalb gibt die Kennlinie 310 an, welche Umgebungstemperatur bei der jeweils auftretenden internen Verlustleistung Pd maximal zulässig ist, um eine übermäßige Erwärmung des Bausteins 20 zu verhindern und dessen einwandfreien Betrieb zu gewährleisten.

In der Vorrichtung 100 von Fig. 1 bzw. 100' von Fig. 2 entsteht in der internen Endstufe 27 nur eine relativ geringe Verlustleistung, da diese nicht als Leistungsendstufe arbeitet. Hierzu wird vielmehr die externe Endstufe 50 (Fig. 1) bzw. 50' (Fig. 2) verwendet.

Wenn z.B. die Kennlinie 310 anzeigt, dass eine maximale Umgebungstemperatur Ta von 100° C für den Baustein 20 möglich ist, sofern die interne Endstufe 27 als Leistungsendstufe betrieben wird und der Baustein 20 dementsprechend eine interne Verlustleistung von annähernd 220 mW erzeugt, ist also bei Verwendung der externen Endstufe 50 bzw. 50' durch Reduzierung der internen Verlustleistung des Bausteins 20 eine höhere Umgebungstemperatur möglich. Diese kann (unter Berücksichtigung einer jeweils bestimmten internen Verlustleistung des Bausteins 20) aus dem gestrichelten Fortsatz 320 der Kurve 310 bestimmt werden.

Weil die Verlustleistung der internen Endstufe 27 reduziert ist, kann also der Hallsensor 24 einer größeren Umgebungstemperatur ausgesetzt werden, ohne dass es zum undefinierten Schalten aufgrund einer zu hohen Temperaturempfindlichkeit kommt. Somit kann die Vorrichtung 100 gemäß Fig. 1 bzw. 100' gemäß Fig. 2 bei relativ hohen Umgebungstemperaturen betrieben werden.

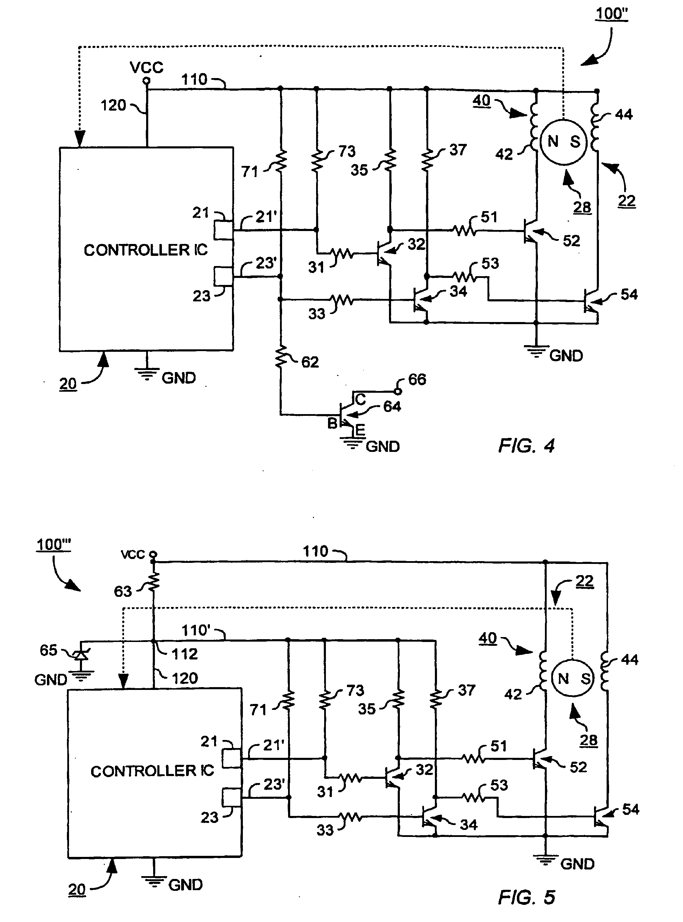

Fig. 4 zeigt eine Variante 100" der Vorrichtung 100 gemäß Fig. 1. Diese Variante enthält alle Elemente der Vorrichtung 100 von Fig. 1. Zusätzlich hat die Vorrichtung 100" einen Drehzahlausgang 66. Dieser ist hier beispielhaft als Open-Collector-Ausgang realisiert und mit dem Kollektor eines Transistors 64 verbunden, dessen Emitter mit Masse (GND) verbunden ist. Seine Basis ist über einen Widerstand 62 mit dem Open-Collector-Ausgang 23 des Bausteins 20 verbunden, um aus dessen Ausgangssignal ein Drehzahlsignal zu erzeugen.

Fig. 5 zeigt ein Schaltbild einer anderen Variante 100"', welche ebenfalls alle Elemente der Vorrichtung 100 (Fig. 1) enthält.

Im Gegensatz zu Fig. 1 ist hier die Versorgungsleitung 110 nur direkt mit den oberen Enden der Wicklungsstränge 42, 44 verbunden. Die Widerstände 35, 37, 71, 73 sind mit einer zusätzlichen Versorgungsleitung 110' verbunden, welche einen Knotenpunkt 112 hat, der über einen Widerstand 63 mit der Versorgungsleitung 120 für den IC 20 verbunden ist. Der Knotenpunkt 112 ist auch mit der Katode einer Z-Diode 65 verbunden, deren Anode mit Masse verbunden ist. Der Widerstand 63 und die Diode 65 bilden eine Einrichtung zur Stabilisierung der Versorgungsspannung VCC für den Baustein 20. Durch diese Schaltung kann der Baustein 20 auch für Motoren verwendet werden, die mit einer höheren Betriebsspannung betrieben werden (UB_Motor >> UB_Motorsteuerbaustein).

Falls der Baustein 20 für seinen Betrieb größere Ströme benötigt, d.h. z.B. Ströme von mehr als 15 mA, kann diese Stabilisierungseinrichtung durch eine Z-Diode und einen Längstransistor realisiert werden, welche zur Aufnahme derart hoher Ströme geeignet sind. Auch hier ist der Stabilisierungsaufwand sehr gering, da der Aufnahmestrom des Motorsteuerbausteins im Vergleich zum Motorstrom sehr gering ist. Würde man dagegen die interne Endstufe des Motorsteuerbausteins benutzen, so müsste gleichzeitig der gesamte Motorstrom stabilisiert werden.

Naturgemäß sind im Rahmen der vorliegenden Erfindung vielfache Abwandlungen und Modifikationen möglich.

## Patentansprüche

1. Elektronisch kommutierter Elektromotor (100, 100', 100", 100"'), welcher aufweist:
Einen permanentmagnetischen Rotor (28);
einen Stator mit einer Statorwicklungsanordnung (40);
einen als IC ausgebildeten integrierten Motorsteuerbaustein (20) mit einer Steuerlogik (27) und einer internen Endstufe (29) mit mindestens einem Open-Collector-Ausgang (21, 23), wobei die Steuerlogik (27) dazu ausgebildet ist, mindestens ein Rotorstellungssignal (24', 24") zu verarbeiten und daraus mindestens ein Steuersignal (27') für die interne Endstufe (29) zu erzeugen, welches mindestens eine Steuersignal (27') dazu dient, die interne Endstufe (29) zur Erzeugung eines Ausgangssignals (21', 23') an dem mindestens einen Open-Colledor-Ausgang (21, 23) des Motorsteuerbausteins (20) anzusteuern ; **gekennzeichnet durch**
eine vom Motorsteuerbaustein (20) separate externe Endstufe (50) zur Beeinflussung der Bestromung der Statorwicklungsanordnung (40), und **durch**
eine Invertierungslogik (30), welche dazu ausgebildet ist, das an dem mindestens einen Open-Collector-Ausgang (21, 23) erzeugte Ausgangssignal (21', 23') zwecks Erzeugung von Kommutierungssignalen (51', 53') für die externe Endstufe (50) umzuformen.

2. Elektromotor nach Anspruch 1, bei welchem die Invertierungslogik (30) dazu ausgebildet ist, beim Vorliegen eines logischen Signals "LOW" an einem Open-Collector-Ausgang (21, 23) ein Kommutierungssignal (51', 53') derart zu erzeugen, dass die externe Endstufe (50) eine Bestromung durch die Statorwicklungsanordnung (46) bewirkt.

3. Elektromotor nach Anspruch 1 oder 2, bei welchem die Invertierungslogik (30) dazu ausgebildet ist, beim Vorliegen eines logischen Signals "TRISTATE" am Open-Cottector-Ausgang (21, 23) ein Kommutierungssignal (51', 53') derart zu erzeugen, dass die externe Endstufe (50) die Bestromung der Statorwicklungsanordnung (40) unterbricht.

4. Elektromotor nach einem der Ansprüche 1 bis 3, bei welchem der Motorsteuerbaustein (20) zwei Open-Collector-Ausgänge (21, 23) aufweist,
und die interne Endstufe (29) dazu ausgebildet ist, jeweils an höchstens einem der beiden Open-Collector-Ausgänge (21, 23) ein logisches Signal "LOW" zu erzeugen.

5. Elektromotor nach Anspruch 4, bei welchem die Statorwicklungsanordnung (40) zwei Wicklungsstränge (42, 44) aufweist, wobei jedem dieser Wicklungsstränge einer der beiden Open-Collector-Ausgänge (21, 23) zugeordnet ist,
und die Invertierungslogik (30) dazu ausgebildet ist, beim Vorliegen des logischen Signals "LOW" an dem betreffenden Open-Collector-Ausgang (21, 23) die Kommutierungssignale (51', 53') so zu erzeugen, dass eine Bestromung des dem betreffenden Open-Collector-Ausgang (21, 23) zugeordneten Wicklungsstrangs (40, 44) durch die externe Endstufe erfolgt.

6. Elektromotor nach Anspruch 4 oder 5, bei welchem die Invertierungslogik (30) dazu ausgebildet ist, beim Vorliegen eines logischen Signals "TRISTATE" an den Open-Collector-Ausgängen (21, 23) die Kommutierungssignale (51', 53') derart zu erzeugen, dass die externe Endstufe (50) den zugeordneten Strom durch die Statorwicklungsanordnung (40) unterbricht.

7. Elektromotor nach einem der vorhergehenden Ansprüche, bei welchem die Invertierungslogik (30) mindestens einen Halbleiterschalter (32, 34) aufweist, der dazu ausgebildet ist, das an dem mindestens einen Open-Collector-Ausgang (21, 23) erzeugte Ausgangssignal (21', 23') zu einem invertierten Signal (51', 53') umzuformen.

8. Elektromotor nach einem der vorhergehenden Ansprüche, bei welchem der Invertierungslogik (30) ein Verzögerungsglied (35, 37, 51, 53) zur Beeinflussung von Schaltzeitpunkten der externen Endstufe (50) zugeordnet ist.

9. Elektromotor nach Anspruch 8, bei welchem das Verzögerungsglied (35, 37, 51, 53) dazu ausgebildet ist, die Ein- und Ausschaltzeitpunkte der externen Endstufe (50) derart zu beeinflussen, dass im Betrieb mindestens eine in der Statorwicklungsanordnung (40) induzierte Spannung reduziert wird.

10. Elektromotor nach einem der vorhergehenden Ansprüche, welcher eine Anordnung (90) zur Begrenzung von Spannungsspitzen aufweist, welche im Betrieb in der Statorwicklungsanordnung (40) auftreten.

11. Elektromotor nach Anspruch 10, bei welchem die Anordnung (90) zur Spannungsbegrenzung (90) einen Zwischenkreiskondensator (92) zur Aufnahme eines Rückspeisestroms aufweist, welcher im Betrieb des Motors auftritt.

12. Elektromotor nach einem der vorhergehenden Ansprüche, bei welchem die externe Endstufe (50, 50') als Endstufen-Halbleiterschalter mindestens einen Feldeffekttransistor (52', 54') aufweist.

13. Elektromotor nach Anspruch 12, bei welchem die externe Endstufe (50, 50') ein Spannungsbegrenzungsglied zur Begrenzung der Drain-Spannung des Feldeffekttransistors (52', 54') aufweist.

14. Elektromotor nach Anspruch 13, bei welchem das Spannungsbegrenzungsglied mindestens eine Z-Diode (87, 88) aufweist.

15. Elektromotor nach Anspruch 13 oder 14, bei welchem das Spannungsbegrenzungsglied eine Schaltung (81, 83, 82, 84) zur Verlangsamung von Ein- und Ausschaltvorgängen des Feldeffekttransistors (52', 54') aufweist.

16. Elektromotor nach Anspruch 14 oder 15, bei welchem das Spannungsbegrenzungsglied eine Fußpunktdiode (89) aufweist.

17. Elektromotor nach einem der vorhergehenden Ansprüche, bei welchem eine Einrichtung (63, 65) zur Stabilisierung einer Versorgungsspannung für den Motorsteuerbaustein (20) vorgesehen ist.

18. Elektromotor nach einem der vorhergehenden Ansprüche, welcher einen Blockierschutz (26) aufweist, der im Fehlerfall eine Abschaltung des Motors bewirkt.

19. Elektromotor nach einem der vorhergehenden Ansprüche, bei welchem ein Signal an mindestens einem Open-Collector-Ausgang (21, 23) zur Erzeugung eines Drehzahlsignals dient.

20. Elektromotor nach einem der vorhergehenden Ansprüche, bei welchem der Motorsteuerbaustein (20) einen Hallsensor (24) aufweist, der im Magnetfeld des permanentmagnetischen Rotors (28) angeordnet ist.

21. Elektromotor nach einem der vorhergehenden Ansprüche, bei welchem der integrierte Motorsteuerbaustein als ASIC ausgebildet ist.

22. Elektromotor nach einem der vorhergehenden Ansprüche, bei welchem der integrierte Motorsteuerbaustein (20), die Invertierungslogik (30), und die externe Endstufe (50), zusammen auf einer Leiterplatte oder einem sonstigen Bauteileträger angeordnet sind.

## Claims

1. Electronically commutated electric motor (100, 100', 100", 100"'), having:
a permanently magnetic rotor (28);
a stator with a stator winding arrangement (40);
a motor control component (20) in the form of an integrated circuit, with control logic (27) and an internal output stage (29) with at least one open collector output (21, 23), the control logic (27) being in a form to process at least one rotor position signal (24', 24") and to generate at least one control signal (27') for the internal output stage (29) from it, said at least one control signal (27') being used to drive the internal output stage (29) to generate an output signal (21', 23') at the at least one open collector output (21, 23) of the motor control component (20); **characterized by**
an external output stage (50) which is separate from the motor control component (20), to influence the flow of current through the stator winding arrangement (40), and by
inversion logic (30), which is in a form to transform the output signal (21', 23') which is generated at the at least one open collector output (21, 23) to generate commutation signals (51', 53') for the external output stage (50).

2. Electric motor according to Claim 1, wherein the inversion logic (30) is in a form to generate a commutation signal (51', 53') when a logical signal "LOW" is present at an open collector output (21, 23), in such a way that the external output stage (50) causes a flow of current through the stator winding arrangement (46).

3. Electric motor according to Claim 1 or 2, wherein the inversion logic (30) is in a form to generate a commutation signal (51', 53') when a logical signal "TRISTATE" is present at the open collector output (21, 23), in such a way that the external output stage (50) interrupts the flow of current through the stator winding arrangement (40).

4. Electric motor according to any one of Claims 1 to 3, wherein the motor control component (20) has two open collector outputs (21, 23), and the internal output stage (29) is a form to generate a logical signal "LOW" at one at most of the two open collector outputs (21, 23).

5. Electric motor according to Claim 4, wherein the stator winding arrangement (40) has two winding phases (42, 44), each of these winding phases being associated with one of the two open collector outputs (21, 23), and the inversion logic (30) being in a form to generate the commutation signals (51', 53') when the logical signal "LOW" is present at the relevant open collector output (21, 23), in such a way that current is caused to flow through the winding phase (40, 44) associated with the relevant open collector output (21, 23) by the external output stage.

6. Electric motor according to Claim 4 or 5, wherein the inversion logic (30) is in a form to generate the commutation signals (51', 53') when a logical signal "TRISTATE" is present at the open collector outputs (21, 23), in such a way that the external output stage (50) interrupts the associated current through the stator winding arrangement (40).

7. Electric motor according to any one of the preceding claims, wherein the inversion logic (30) has at least one semiconductor switch (32, 34), which is in a form to transform the output signal (21', 23') which is generated at the at least one open collector output (21, 23) into an inverted signal (51', 53').

8. Electric motor according to any one of the preceding claims, wherein a delay element (35, 37, 51, 53) is associated with the inversion logic (30), to influence switching instants of the external output stage (50).

9. Electric motor according to Claim 8, wherein the delay element (35, 37, 51, 53) is in a form to influence the switching-on and switching-off instants of the external output stage (50), in such a way that in operation, at least one voltage which is induced in the stator winding arrangement (40) is reduced.

10. Electric motor according to any one of the preceding claims, having an arrangement (90) to limit voltage peaks which occur in operation in the stator winding arrangement (40).

11. Electric motor according to Claim 10, wherein the arrangement (90) to limit voltage has an intermediate circuit capacitor (92) to receive a feedback current which occurs in operation of the motor.

12. Electric motor according to any one of the preceding claims, wherein the external output stage (50) has at least one field effect transistor (52', 54') as an output stage semiconductor switch.

13. Electric motor according to Claim 12, wherein the external output stage (50, 50') has a voltage limitation element to limit the drain voltage of the field effect transistor (52', 54').

14. Electric motor according to Claim 13, wherein the voltage limitation element has at least one Z diode (87, 88).

15. Electric motor according to Claim 13 or 14, wherein the voltage limitation element has a circuit (81, 82, 83, 84) to slow down the switching-on and switching-off processes of the field effect transistor (52', 54').

16. Electric motor according to Claim 14 or 15, wherein the voltage limitation element has a base point diode (89).

17. Electric motor according to any one of the preceding claims, wherein a device (63, 65) to stabilise a supply voltage for the motor control component (20) is provided.

18. Electric motor according to any one of the preceding claims, having a blocking protection (26), which in the case of a fault causes the motor to be switched off.

19. Electric motor according to any one of the preceding claims, wherein a signal at at least one open collector output (21, 23) is used to generate a rotational speed signal.

20. Electric motor according to any one of the preceding claims, wherein the motor control component (20) has a Hall sensor (24), which is arranged in the magnetic field of the permanently magnetic rotor (28).

21. Electric motor according to any one of the preceding claims, wherein the integrated motor control component is in the form of an ASIC.

22. Electric motor according to any one of the preceding claims, wherein the integrated motor control component (20), the inversion logic (30) and the external output stage (50) are arranged together on a printed circuit board or another component carrier.

## Revendications

1. Moteur électrique à commutation électronique (100, 100', 100", 100"'), lequel présente :
un rotor à aimant permanent (28) ;
un stator avec un arrangement d'enroulement statorique (40) ;
un composant de commande de moteur intégré (20) réalisé sous la forme d'un circuit intégré et comprenant une logique de commande (27) et un étage final interne (29) avec au moins une sortie à collecteur ouvert (21, 23), la logique de commande (27) étant conçue pour traiter au moins un signal de position de rotor (24', 24") et générer à partir de celui-ci au moins un signal de commande (27') pour l'étage final interne (29), ledit au moins un signal de commande (27") servant à commander l'étage final interne (29) pour générer un signal de sortie (21', 23') à ladite au moins une sortie à collecteur ouvert (21, 23) du composant de commande de moteur (20) ;
**caractérisé par**
un étage final externe (50) séparé du composant de commande de moteur (20) pour influencer l'alimentation en courant de l'arrangement d'enroulement statorique (40), et par
une logique d'inversion (30) qui est conçue pour transformer le signal de sortie (21', 23') généré à la dite au moins une sortie à collecteur ouvert (21, 23) en vue de générer des signaux de commutation (51', 53') pour l'étage final externe (50).

2. Moteur électrique selon la revendication 1, dans lequel la logique d'inversion (30) est conçue pour, en cas de présence d'un signal logique «LOW» à une sortie à collecteur ouvert (21, 23), générer un signal de commutation (51', 53') de façon que l'étage final externe (50) entraîne une alimentation en courant à travers l'arrangement d'enroulement statorique (46).

3. Moteur électrique selon la revendication 1 ou 2, dans lequel la logique d'inversion (30) est conçue pour, en cas de présence d'un signal logique «TRISTATE» à la sortie à collecteur ouvert (21, 23), générer un signal de commutation (51', 53') de façon que l'étage final externe (50) interrompe l'alimentation en courant de l'arrangement d'enroulement statorique (40).

4. Moteur électrique selon une des revendications 1 à 3, dans lequel le composant de commande de moteur (20) présente deux sorties à collecteur ouvert (21, 23), et l'étage final interne (29) est conçu pour générer un signal logique «LOW» chaque fois à au maximum une des deux sorties à collecteur ouvert (21, 23).

5. Moteur électrique selon la revendication 4, dans lequel l'arrangement d'enroulement statorique (40) présente deux phases d'enroulement (42, 44), une des deux sorties à collecteur ouvert (21, 23) étant associée à chacune de ces phases d'enroulement,
et la logique d'inversion (30) est conçue pour, en cas de présence du signal logique «LOW» à la sortie à collecteur ouvert (21, 23) concernée, générer les signaux de commutation (51', 53') de façon que la phase d'enroulement (40, 44) associée à la sortie à collecteur ouvert (21, 23) concernée soit alimentée en courant à travers l'étage final externe.

6. Moteur électrique selon la revendication 4 ou 5, dans lequel la logique d'inversion (30) est conçue pour, en cas de présence d'un signal logique «TRISTATE» aux sorties à collecteur ouvert (21, 23), générer les signaux de commutation (51', 53') de façon que l'étage final externe (50) interrompe le courant associé à travers l'arrangement d'enroulement statorique (40).

7. Moteur électrique selon une des revendications précédentes, dans lequel la logique d'inversion (30) présente au moins un commutateur à semi-conducteurs (32, 34) qui est conçu pour transformer le signal de sortie (21', 23') généré à ladite au moins une sortie à collecteur ouvert (21, 23) en un signal inversé (51', 53').

8. Moteur électrique selon une des revendications précédentes, dans lequel un élément de retard (35, 37, 51, 53) servant à influencer les instants de commutation de l'étage final externe (50) est associé à la logique d'inversion (30).

9. Moteur électrique selon la revendication 8, dans lequel l'élément de retard (35, 37, 51, 53) est conçu pour influencer les instant d'activation et de désactivation de l'étage final externe (50) de façon qu'en fonctionnement au moins une tension induite dans l'arrangement d'enroulement statorique (40) soit réduite.

10. Moteur électrique selon une des revendications précédentes, lequel présente un arrangement (90) pour limiter les pointes de tension qui apparaissent en fonctionnement dans l'arrangement d'enroulement statorique (40).

11. Moteur électrique selon la revendication 10, dans lequel l'arrangement (90) de limitation de tension (90) présente un condensateur de circuit intermédiaire (92) servant à absorber un courant de retour qui apparaît pendant le fonctionnement du moteur.

12. Moteur électrique selon une des revendications précédentes, dans lequel l'étage final externe (50, 50') présente au moins un transistor à effet de champ (52', 54') en tant que commutateur à semi-conducteurs d'étage final.

13. Moteur électrique selon la revendication 12, dans lequel l'étage final externe (50, 50') présente un élément de limitation de tension pour limiter la tension de drain du transistor à effet de champ (52', 54').

14. Moteur électrique selon la revendication 13, dans lequel l'élément de limitation de tension présente au moins une diode Zener (87, 88).

15. Moteur électrique selon la revendication 13 ou 14, dans lequel l'élément de limitation de tension présente un circuit (81, 83, 82, 84) servant à ralentir les cycles d'activation et de désactivation du transistor à effet de champ (52', 54').

16. Moteur électrique selon la revendication 14 ou 15, dans lequel l'élément de limitation de tension présente une diode de point de base (89).

17. Moteur électrique selon une des revendications précédentes, dans lequel est prévu un dispositif (63, 65) pour stabiliser une tension d'alimentation pour le composant de commande de moteur (20).

18. Moteur électrique selon une des revendications précédentes, lequel présente une protection anti-blocage (26) qui provoque une déconnexion du moteur en cas de défaut.

19. Moteur électrique selon une des revendications précédentes, dans lequel un signal à au moins une sortie à collecteur ouvert (21, 23) sert à générer un signal de vitesse de rotation.

20. Moteur électrique selon une des revendications précédentes, dans lequel le composant de commande de moteur (20) présente un capteur à effet Hall (24) qui est disposé dans le champ magnétique du rotor à aimant permanent (28).

21. Moteur électrique selon une des revendications précédentes, dans lequel le composant de commande de moteur intégré est réalisé sous la forme d'un ASIC.

22. Moteur électrique selon une des revendications précédentes, dans lequel le composant de commande de moteur intégré (20), la logique d'inversion (30) et l'étage final externe (50) sont disposés ensemble sur une carte de circuits imprimés ou un autre support de composants.
